Europäisches Patentamt

European Patent Office

Office européen des brevets

(11) Publication number: **0 358 879**
**A2**

## EUROPEAN PATENT APPLICATION

(21) Application number: **89112791.2**

(51) Int. Cl.⁵: **H01L 23/532**

(22) Date of filing: **12.07.89**

(30) Priority: **13.09.88 US 243948**

(43) Date of publication of application:
**21.03.90 Bulletin 90/12**

(84) Designated Contracting States:
**DE FR GB**

(71) Applicant: **Hewlett-Packard Company**
**3000 Hanover Street**
**Palo Alto California 94304(US)**

(72) Inventor: **Ruby, Richard C.**
**567 9th Avenue**
**Menlo Park California 94025(US)**

(74) Representative: **Liesegang, Roland, Dr.-Ing. et**
**al**
**FORRESTER & BOEHMERT**
**Widenmayerstrasse 4**
**D-8000 München 22(DE)**

(54) Method of making high density interconnects.

(57) A method of making a high density interconnect
with superconductive lines is provided. A layer of
high $T_c$ superconductive material is deposited on an
electrically insulative substrate layer (32) of closely
matching crystal structure. The superconductive lay-
er (30) is then photolithographically patterned to
define part of an electrical interconnect circuit, and
either selectively etched away or ion bombarded to
destroy its superconductivity in noncircuit areas. An-
other layer (34) of insulative material is deposited
over the superconductive lines thus formed, and via
holes (38) are formed therein. The steps are then
repeated for additional layers of superconductive
material and insulative material until a complete in-
terconnect is formed. The high $T_c$ material is super-
conductive at 77 K and has orders of magnitude less
attenuation than copper at the same temperature.

FIG 8

## Method of Making High Density Interconnects

Technical Field

The invention relates to interchip connections or "interconnects", i.e. to the metal traces on multichip carrier substrates that electrically connect two or more semiconductor devices or "chips" to one another. The present invention relates in particular to methods of making high density interconnects.

Background Art

There is a need for higher density interconnects in the computer industry, a need which arises as computing machines incorporate more parallelism, e.g. as when computers went from 16-bit to 32-bit architectures. Density can be increased by scaling line dimensions, such as by scaling the width and thickness of the metal traces that make up the interconnection circuit, the separations between traces and the thickness of the dielectric between trace and ground planes. Higher density can also be increased by adding more layers to the interconnect package. Whenever density is increased by scaling it is important to keep crosstalk between interconnect lines to a minimum, if possible, and at the very least to keep it constant. As or more important than crosstalk is the effect of any attenuation and dispersion of a signal on the lines, since these can modify the waveform of a signal as it propagates down a transmission line, and thereby degrade the signal. Attenuation varies approximately as the square of the scaling factor. Thus, a tenfold increase in density due to scaling alone will result in a hundredfold increase in the attenuation.

Currently, interconnects with the highest density are constructed out of multilayer ceramic with 34 or more layers and using copper traces, and also copper-polyimide chip carriers with one or two layers. Since attenuation and dispersion are proportional to line resistance, the interconnect packages may be cooled to liquid nitrogen temperatures (77 K), reducing the resistivity of the copper traces tenfold and thereby allowing a threefold increase in density. However, the attenuation and dispersion of existing interconnect packages, even when cooled to 77 K, is already near the acceptable limit.

A wide variety of possible applications for high temperature superconductivity have been discussed recently. These include large scale applications, such as power transmission, superconducting magnets, motors and transformers. Also discussed have been smaller scale applications such as Josephson devices, measurement instruments and sensors, electromagnetic shielding and computer chip interconnects. Many of the applications were explored in great detail with conventional superconducting materials in mind, while others were merely speculative until the recent discovery of the high $T_c$ superconductors, such as $YBa_2Cu_3O_7$, having critical temperatures above 77 K. As the transition temperatures of known superconductors have been increasing, the operating temperatures of semiconductor devices have been decreasing. If interconnects could be made with superconductive traces, then one could use extremely thin dielectrics as the insulator and very small scale traces. In normal copper, the attenuation would make such a scheme impractical. However, the attenuation of the high $T_c$ superconductors at 77 K is orders of magnitude less than copper at the same temperature, making higher density possible. What is required is a method of making these high density interconnects.

An object of the present invention is to produce a method of making high density interconnects for multichip carrier substrates.

Disclosure of the Invention

The above object has been met with a method which photolithographically patterns a high $T_c$ superconductive material layer to form superconductive traces on an insulative substrate. First, a layer of high $T_c$ superconductive material is deposited onto an electrically insulative material layer. The insulative layer and the layer of superconductive material have a closely matching crystal structure. Next, the superconductive layer is patterned using a conventional photolithographic process and either (1) selectively etched away or (2) ion bombarded in such a fashion as to convert it into an insulator. The remaining unetched portion or the unconverted portion of the superconductive layer forms part of a superconductive electrical interconnection circuit. Another layer of insulative material is deposited over the superconductive circuit layer and via holes are formed therein. The steps are then repeated for additional layers of superconductive and insulative material until a complete interconnect is formed.

Because relatively thin layers of superconductive material can be deposited, one can push the limits of optical lithography without concern for depth of focus, even after many layers have been etched. Further, in the case of ion bombardment, the fact that the surfaces are planar even after forming the superconductive circuits, means that photolithography can be pushed even further and more layers can be used. Use of superconductive traces, having low attenuation and no dispersion, means that the line density can be made very high, compared to copper traces, without significant signal degradation.

Brief Description of the Drawings

Figs. 1-4 are side sectional views of a superconductive interconnect in various stages of production, illustrating a first method of the present invention of making the interconnects.

Figs. 5-10 are side sectional views of another superconductive interconnect in various stages of production, illustrating a second and preferred method of the present invention of making the interconnect.

Best Mode for Carrying Out the Invention

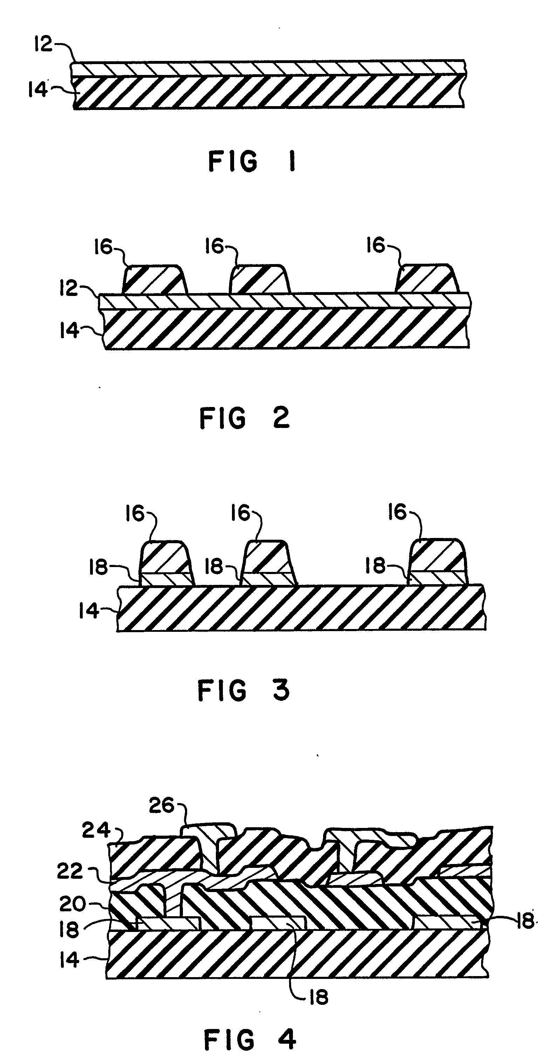

With reference to Fig. 1, in order to make a high density interconnect, a high critical temperature ($T_c$) superconductor material is deposited as a thin layer 12 on an electrically insulative substrate layer 14. By high $T_c$ material we mean a material which has a critical temperature above 77 K and is therefore superconductive at liquid nitrogen temperatures. This includes the recently discovered class of superconductors having a perovskite crystal structure, such as $YBa_2Cu_3O_7$. Preferably, the critical temperature will be at least 100 K. The film 12 should be no more than 3000 to 4000 Angstroms thick.

The thin superconductive layer 12 and insulative layer 14 should have a closely matching crystal structure so that the layer 12 can be laid down with a minimum of flaws and dislocations. The perovskite crystal structure of the recently discovered high $T_c$ superconductors is made up of unit cells which are sets of cubes with the large metal ions located in the cube centers, the smaller metal ions, typically copper, located on the cube corners and nonmetallic anions, typically oxygen, located on the cube edges. For example, $YBa_2Cu_3O_7$ is a repeating structure of three cubes stacked upon one another, with yttrium occupying the center of the central cube and barium occupying the centers of the outer cubes. Oxygen is lacking on the vertical edges of the yttrium cube. One insulative layer material which may be used is $SrTiO_3$, which also has a perovskite crystal structure. Another material which may be used is MgO, which has a simple cubic crystal structure.

The thin superconductive film 12 is deposited by evaporation, sputtering or thick film deposition fol lowed by lapping. The superconductive layer 12 may require heat treatment after deposition to bring out the desired superconducting properties or to improve the current carrying capacity. Whether heat treatment is required depends on the particular high $T_c$ material. Heat treatment or "annealing" can also affect the choice of insulative substrate, since some substrates, such as $SrTiO_3$, have a tendency to interdiffuse during annealing. This can cause problems in some high $T_c$ superconductors that are extremely sensitive to the proportion of individual atoms in the same. Accordingly, MgO is the preferred substrate where heat treatment is required.

In Fig. 2, the next step is patterning the individual lines and via pads in the superconductive layer. One way in which this can be done is to deposit a photoresist layer 16 and to photolithographically pattern the resist using conventional techniques. The pattern should be made such that the resist remains on top of the line locations after development and rinse. The superconductive layer 12 is then selectively etched away, as shown in Fig. 3, using an argon sputter etch to form a portion of a superconductive electric circuit. Areas unprotected by photoresist are etched away, while areas protected by photoresist 16 remain to form superconductive lines and via pads 18 on substrate 14. The photoresist is removed after etching.

Referring to Fig. 4, the next step is to deposit another layer 20 of electrically insulative material on top of the superconductive lines and via pads 18. Via holes 22 are opened up on the insulative layer 20 to the via pads 18 below, using standard photolithography. Preferably, insulative layer 20 is made of the same material as insulative substrate layer 14. The steps of depositing superconductive material 22, patterning and etching to form electrical circuit lines and via pads, and depositing insulative material 24 with via holes 26 is repeated. Additional superconductive and insulative lines are alternately added until a complete interconnect package is formed.

A drawback to the above described etching process is that the topology of the surface is not planarized. Thus, after several layers it would be hard to control line width during the photolithographic patterning step. This limits the number of layers that can be used. However, since the superconductive lines can be thinner than copper lines for the same purpose without increasing attenuation, the maximum allowable number of layers will still be greater than that for interconnects using copper.

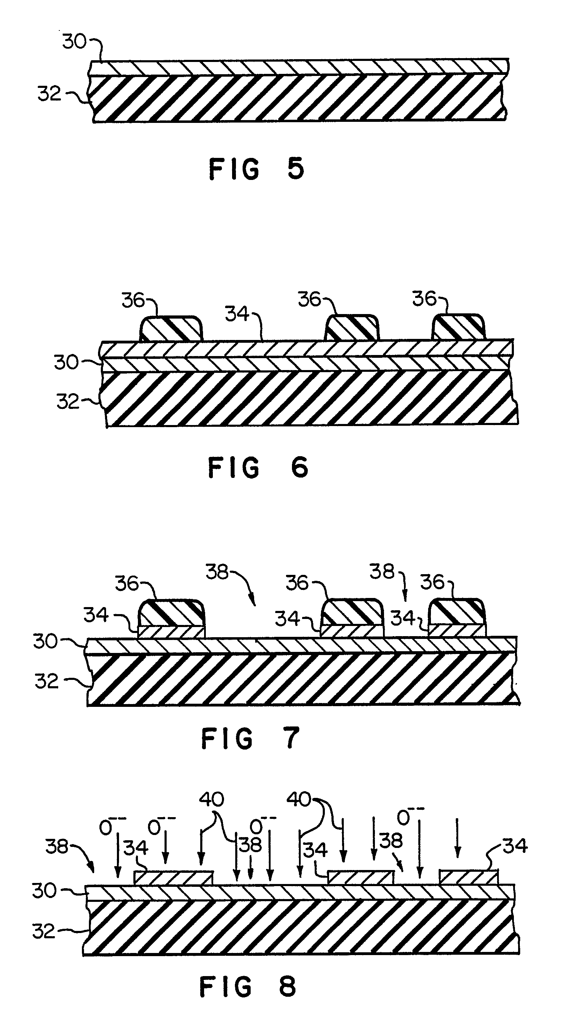

An alternative and preferred process of making interconnects begins in Fig. 5 with deposition of a layer 30 of high $T_c$ superconductive material onto an electrically insulative material substrate layer 32. Again, the materials in the two layers should have closely matching crystal structures. The superconductive layer 30 is then photolithographically patterned so as to define an electrical circuit pattern thereon. As seen in Fig. 6, patterning is done by first depositing a layer of gold 34 onto superconductive layer 30. Photoresist 36 is applied over gold layer 34, and the photoresist is exposed, developed and rinsed to define the pattern. The gold 34 is then selectively removed from areas 38 not corresponding to the pattern and not protected by photoresist 36, as seen in Fig. 7. The photoresist layer 36 is then removed.

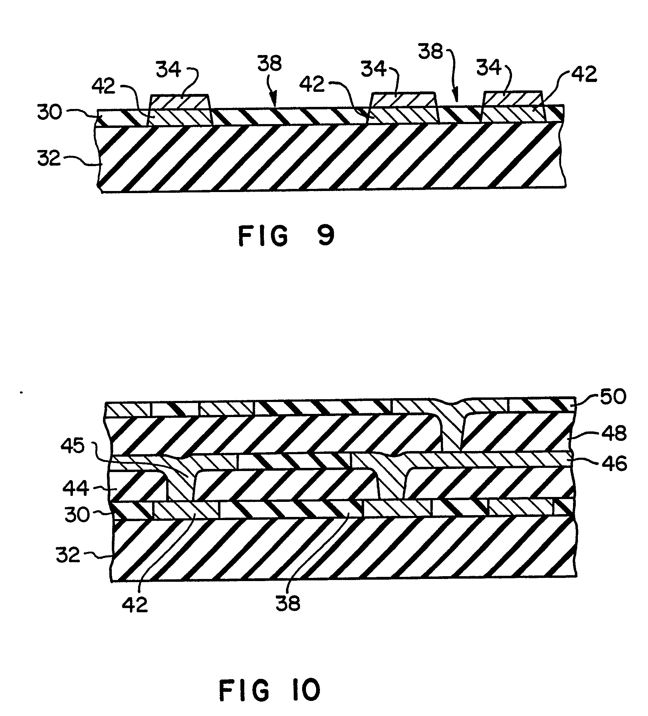

Referring to Fig. 8, the superconductive lines are formed by means of ion implantation with oxygen, as indicated by arrows 40. The oxygen bombardment oxidizes and damages areas 38 of the superconductive layer 30 not protected by the gold pattern 34, destroying all superconductivity in those areas. The advantage of a gold protective pattern over photoresist is its ability to withstand oxygen implantation. Preferably, the oxygen concentration from the implanter is high enough so that a metal-to-insulator transition occurs in the implanted high $T_c$ material, i.e. so that the characteristic of the implanted areas 38 are not merely normal but insulative at 77 K. This would guarantee isolation of the lines from each other on a given layer, even if the system for cooling the interconnect should fail and the superconductive lines should be driven to normal. The result of ion implantation is seen in Fig. 9, layer 30 is now made up of superconductive lines 42 forming a portion of an electrical interconnect circuit separated by the ion converted insulation 38. After implantation, gold layer 34 is removed.

With reference to Fig. 10, another electrically insulative material layer 44 is deposited over the layer 30 of superconductive lines 42 and converted insulator, 38. Preferably, insulative layer 44 is composed of the same material as insulative substrate layer 32. Via holes 45 are opened up in insulative layer 44 over via pads forming part of lines 42. The process is then repeated for additional superconductive and insulative layers 46, 48, 50, etc. until a complete interconnect circuit is formed.

The fact that the surfaces are planar, as compared to the process first described with reference to Figs. 1-4, and that the superconductive layers 30, 46, 50, etc. are rather thin, means that one can push the limits of optical lithography without concern for depth of focus. The high $T_c$ superconductive material will give a superior performance over copper traces in interconnects at the same temperature when the dimensions of the lines are less or equal to 10 $\mu$m and the pitches (lines plus spaces between the lines) are less than or equal to 25 $\mu$m. These values will of course vary depending on the number of loads on the line and the maximum length of the line.

To take full advantage of high density interconnects, a process known as "flip-chipping" is done. This entails placing solder bumps directly on the pads of the IC chip and flipping the chip upside down onto the surface of the interconnect package. In the case of the present invention, in which high $T_c$ superconductive lines are used and the package operates at reduced temperatures (typically 77 K), the solder may be either indium or mercury. The lack of superconductivity in the solder bumps, which connect the chip pads to the interconnects on the high density package, is not fatal. This is due to the fact that the bumps are small relative to the smallest wavelength of the transmitted signal. An interconnect line length can, on the other hand, be several wavelengths long and thus degrade the signal if superconductive material is not used in the lines. The present invention described above is a method for making these interconnect packages with superconductive lines so that high density can be obtained without degrading the signal.

## Claims

1. A method of making high density interconnects, **characterized** by

a) depositing a layer (12, 30) of high $T_c$ superconductive material on to an electrically insulative material layer (14, 32), said insulative layer and said layer of high $T_c$ superconductive material having a closely matching crystal structure,

b) photolithographically patterning said layer of high $T_c$ superconductive material so as to define an electrical circuit pattern thereon,

c) ion bombarding said patterned material so as to convert unprotected regions of said material into an electrical insulator, unconverted high $T_c$ material forming part of a superconductive electrical circuit,

d) depositing a layer of electrically insulative material on said layer of superconductive circuit and ion converted insulative material,

e) forming via holes in said layer of electrically insulative material, and

f) repeating steps (a) through (e) for additional layers of high $T_c$ superconductive material and electrically insulative material, until a complete circuit interconnect is formed.

2. The method of claim 1, **characterized** in that photolithographically patterning said layer (30) of high $T_c$ superconductive material comprises depositing a layer (34) of gold on said layer of high $T_c$ superconductive material, photolithographically patterning said gold layer with photoresist, selectively removing areas (38) of said gold layer not corresponding to said electrical circuit pattern, and removing said photoresist.

3. The method of claim 1 or 2, **characterized** in that ion bombarding said patterned material comprises implanting oxygen ions into unprotected regions of said patterned material layer so as to oxidize said material and destroy the superconductivity of said material.

4. The method of one of claims 1 to 3, **characterized** by heating said layer deposited in step a).

5. A method of making high density interconnects, **characterized** by

a) depositing a layer (12) of high $T_c$ superconductive material onto an electrically insulative material layer (14), said insulation layer and said superconductive layer having a closely matching crystal structure,

b) photolithographically patterning said superconductive layer so as to define an electrical circuit pattern (18) thereon,

c) etching away unprotected regions of said patterned superconductive layer, the remaining material in said layer forming part of a superconductive electrical interconnect circuit,

d) depositing a layer (20) of electrically insulative material on said superconductive layer,

e) forming via holes (26) in said insulative layer, and

f) repeating steps a) through e) for additional layers of high $T_c$ superconductive material and electrically insulative material, until a complete circuit is formed.

6. The method of one of claims 1 to 5, **characterized** in that said electrically insulative material layers (14, 20, 32) have a perovskite crystal structure.

7. The method of one of claims 1 to 5, **characterized** in that said electrically insulative material layers are composed of MgO and/or Lanthanum Aluminate or Lanthanum Galeate.

8. The method of one of claims 1 to 7, **characterized** in that photolithographically patterning said superconductive layer comprises applying photoresist (16, 36) to said superconductive layer (12, 30), photolithographically patterning said photoresist and selectively removing areas of said photoresist not corresponding to said electrical circuit pattern.

9. A high density interconnect package for a multichip carrier, **characterized** by

an electrically insulative material substrate layer (14),

a first layer (18) of high $T_c$ superconductive material on said substrate layer forming a part of a superconductive electrical circuit,

a second layer (20) of electrically insulative material disposed over said superconductive layer, said insulative layer having vias formed therein,

one or more alternating additional layers (22, 24) of superconductive and insulative material disposed over said second layer (20) of insulative material, said superconductive layers forming part of a superconductive electrical circuit electrically connected to parts of said circuit in other layers by means of vias formed in said insulative layers so as to form a complete interconnection circuit.

12
14

**FIG 1**

16    16    16
12
14

**FIG 2**

16    16    16
18    18    18
14

**FIG 3**

26
24
22
20
18
14
18    18

**FIG 4**

30

32

FIG  5

36  36  34  36  36

30

32

FIG  6

36  38  36  38  36

34  34  34

30

32

FIG  7

40  40

O⁻⁻  O⁻⁻  O⁻⁻  O⁻⁻

38  34  38  34  34

30

32

FIG  8

FIG 9

FIG 10